Europäisches Patentamt

(19) European Patent Office

Office européen des brevets

(11) Publication number : **0 461 609 B1**

(12) **EUROPEAN PATENT SPECIFICATION**

(45) Date of publication of patent specification :
06.04.94 Bulletin 94/14

(51) Int. Cl.⁵ : **C04B 41/88, C04B 35/58**

(21) Application number : **91109545.3**

(22) Date of filing : **11.06.91**

(54) **Method of forming metallized layer on aluminum nitride base material.**

(30) Priority : **15.06.90 JP 158145/90**

(43) Date of publication of application :
**18.12.91 Bulletin 91/51**

(45) Publication of the grant of the patent :
**06.04.94 Bulletin 94/14**

(84) Designated Contracting States :
**DE FR GB IT**

(56) References cited :
**PATENT ABSTRACTS OF JAPAN, unexamined
applications, C field, vol. 13, No. 290, July 5,
1989, THE PATENT OFFICE JAPANESE GOV-
ERNMENT, page 28 C 614
PATENT ABSTRACTS OF JAPAN, unexamined
applications, C field, vol. 13, No. 290, July 5,
1989, THE PATENT OFFICE JAPANESE GOV-
ERNMENT, page 28 C 614
PATENT ABSTRACTS OF JAPAN, unexamined
applications, C field, vol. 13, No. 592, Decem-
ber 26, 1989, THE PATENT OFFICE JAPANESE
GOVERNMENT, page 90 C 671**

(73) Proprietor : **SUMITOMO ELECTRIC
INDUSTRIES, LIMITED
5-33, Kitahama 4-chome Chuo-ku
Osaka (JP)**

(72) Inventor : **Yamakawa, Akira, c/o Itami Works of
Sumitomo
Electric Industries, Ltd., 1-1, Koyakita 1-chome
Itami-shi, Hyogo (JP)**
Inventor : **Ogasa, Nobuo, c/o Itami Works of
Sumitomo
Electric Industries, Ltd., 1-1, Koyakita 1-chome
Itami-shi, Hyogo (JP)**

(74) Representative : **Herrmann-Trentepohl,
Werner, Dipl.-Ing. et al
Patentanwälte Herrmann-Trentepohl,
Kirschner, Grosse, Bockhorni & Partner
Forstenrieder Allee 59
D-81476 München (DE)**

## Description

The present invention relates to a method of forming a metallized layer on a surface of an aluminum nitride base material, and more particularly, it relates to a method of forming a metallized layer containing high melting metal as a metal component.

In recent years, a semiconductor device has been highly integrated with an increased operating speed, and the degree of integration has been extremely improved particularly in LSI etc. Thus, heat radiation property has been increasingly emphasized as to a substrate material for carrying a semiconductor element thereon.

A ceramic material for such an IC substrate has been generally prepared from alumina ($Al_2O_3$). However, a conventional alumina sintered body has low thermal conductivity and insufficient heat radiation property. Thus, it is difficult to apply such an alumina sintered body to a ceramic material for a substrate, which can sufficiently cope with increase in calorific power of an IC chip.

In place of such an alumina substrate, attention has recently been directed to a substrate or a heat sink which is prepared from alumina nitride having high thermal conductivity, and deep study has been made to put the same into practice.

Aluminum nitride is a material essentially having high thermal conductivity and high insulability, with no toxity dissimilarly to beryllia, which also has high thermal conductivity. Thus, aluminum nitride is expected as an insulating material or a package material for a semiconductor device. However, an aluminum nitride sintered body having the aforementioned characteristics is disadvantageous in junction strength with respect to a metal or vitreous material. Such an aluminum nitride sintered body with a metallized layer on its surface. This metallized layer is formed by a thick film forming method of directly applying commercially available metallized paste onto the surface of the aluminum nitride sintered body, or a thin film method of forming a thin film of an active metal or a metal by a technique such as vapor deposition. In the metallized layer formed by such a method, however, it is impossible to attain sufficiently practicable junction strength with respect to the aluminum nitride sintered body. In practice, therefore, it is necessary to reform the surface of the aluminum nitride sintered body by some technique before or during the metallization step, in order to improve junction strength with respect to a metal, for example.

In a well-known conventional method for such reforming, an oxide layer is formed by oxidizing a surface of an aluminum nitride sintered body.

For example, Japanese Patent Publication No. 58-11390 (1983) discloses a method of forming an oxide layer of $SiO_2$, $Al_2O_3$, mullite, $Fe_2O_3$ and the like on a surface of an aluminum nitride sintered body. However, although such an oxide layer has excellent affinity with respect to a glass layer, an alumina layer etc., it is inferable that the same has small affinity with respect to the aluminum nitride sintered body itself and is disadvantageous in reliability. The wording "reliability" includes such conditions that junction strength between the oxide layer and the aluminum sintered body involves no dispersion, constant junction strength can be maintained in a prescribed heat cycle test, and the like.

On the other hand, Japanese Laying-Open No. 63-115393 (1988) discloses a method of applying conductive paste which is mainly composed of tungsten and/ molybdenum and an agent for reinforcing junction strength prepared from an oxide mixture of $SiO_2$, $Al_2O_3$ and CaO onto an aluminum nitride sintered body and thereafter firing the same at a temperature of at least 1600°C. However, this method has such problems that the firing temperature is too high and the as-formed metallized layer is rather insufficient in reliability.

An object of the present invention is to provide a method of forming a metallized layer on an aluminum nitride base material, which can form a metallized layer having high junction strength and high reliability at a lower firing temperature.

The inventive method of forming a metallized layer on a surface of an aluminum nitride base material comprises the steps of:

(a) preparing an aluminum nitride base material from either an aluminum nitride compact or an aluminum nitride sintered body which is previously formed to have a prescribed configuration;

(b) preparing high melting metal paste containing at least 1 percent by weight and not more than 40 percent by weight of at least one oxide selected from a group of $Al_2O_3$, $SiO_2$, CaO and $Y_2O_3$, at least 0.01 percent by weight and not more than 1.0 percent by weight of at least one iron family metal, and a high melting metal which is composed of tungsten and molybdenum with a weight ratio (W/Mo) of tungsten to molybdenum of at least 1/1 and not more than 1000/1;

(c) applying the high melting metal paste onto a surface of the aluminum nitride base material; and

(d) heating/firing the aluminum nitride base material, which is coated with the high melting metal paste, under a temperature of at least 1400°C and not more than 2000°C.

In relation to the aforementioned step (b), the iron family metal indicates iron, cobalt or nickel.

According to the inventive method of forming a metallized layer, metal paste having a prescribed composition is applied onto a surface of an aluminum nitride sintered body by screen printing or the like, and then fired. Alternatively, such metal paste is applied onto a surface of an aluminum nitride compact such as a pressed body or a sheet compact, and thereafter the aluminum nitride compact is fired simultaneously with the metal paste, to be densified.

The metal paste is mainly composed of oxide powder, iron family metal powder and high melting metal powder, and contains an organic substance in addition. This organic substance is composed of ethyl cellulose resin, nitrocellulose resin or acrylic resin, and a solvent which is responsive to the resin. The oxide powder is an important element in the inventive method of forming a metallized layer. This oxide powder contains at least one oxide selected from a group of $Al_2O_3$, $SiO_2$, $CaO$ and $Y_2O_3$. The metal paste contains at least 1 percent by weight and not more than 40 percent by weight of such an oxide component. If the content of the oxide component is less than 1 percent by weight, the as-formed metallized layer has merely small adhesion strength with respect to the aluminum nitride sintered body. If the amount of the oxide component contained in the metal paste exceeds 40 percent by weight, on the other hand, adhesion strength of the metallized layer with respect to the aluminum nitride sintered body is reduced.

The metal paste contains at least 0.01 percent by weight and not more than 1.0 percent by weight of the iron family metal. The iron family metal is adapted to facilitate sintering of the high melting metal contained in the metal paste. If the amount of the iron family metal contained in the metal paste is less than 0.1 percent by weight, it is not possible to attain the aforementioned object. If the amount of the iron family metal contained in the metal paste exceeds 1.0 percent by weight, on the other hand, adhesive strength between the aluminum nitride sintered body and the metallized layer is reduced.

The high melting metal powder contained in the metal paste is made of a mixture of tungsten powder and molybdenum powder. The weight ratio (W/Mo) of the tungsten powder to the molybdenum powder is at least 1/1 and not more than 1000/1. If the weight ratio of the tungsten powder to the molybdenum powder is less than 1/1, adhesive strength between the metallized layer and the aluminum nitride sintered body is reduced. If the weight ratio of the tungsten powder to the molybdenum powder exceeds 1000/1, on the other hand, the tungsten powder is insufficiently sintered.

When the weight ratio (W/Mo) of the tungsten powder to the molybdenum powder is in the aforementioned range of at least 1/1 and not more than 1000/1, it is possible to attain adhesive strength of at least 5 $kg/mm^2$. When the aforementioned weight ratio (W/Mo) is within a range of at least 5 and not more than 100, further, it is possible to attain adhesive strength of at least 7 $kg/mm^2$.

The components forming the metal paste are sufficiently kneaded with each other by a ball mill, a triple-roll mill, or the like. The as-formed metal paste is applied onto a surface of an aluminum nitride sintered body or an aluminum nitride compact which is formed by a pressed body or a sheet compact, by screen printing, brush application or the like. The aluminum nitride sintered body or the aluminum nitride compact thus coated with the metal paste is then dried and heated/fired in a non-oxidizing atmosphere under a temperature of at least 1400°C and not more than 2000°C. When the metal paste is applied onto a surface of an aluminum nitride sintered body, this sintered body is preferably heated/sintered in an atmosphere containing hydrogen under a temperature of at least 1400°C and not more than 1600°C. When the metal paste is applied onto a surface of an aluminum nitride compact, on the other hand, this compact is heated/fired in an atmosphere containing nitrogen under a temperature of at least 1600°C and not more than 2000°C. If the firing temperature is less than the lower limit in each heating/firing condition, sintering is so insufficient that the as-formed metallized layer is not improved in adhesive strength with respect to the aluminum nitride sintered body or compact. If the firing temperature exceeds the upper limit in each condition, on the other hand, adhesive strength of the metallized layer is rather reduced with respect to the aluminum nitride sintered body or compact.

The foregoing and other objects, features, aspects and advantages of the present invention will become more apparent from the following detailed description of the present invention when taken in conjunction with the accompanying drawings.

Fig. 1 is a side elevational view showing a method of measuring peel strength of a lead frame which is joined onto an aluminum nitride sintered carrier through a metallized layer; and

Fig. 2 is a graph showing relations between weight ratios (W/Mo) of tungsten powder to molybdenum powder contained in metal paste materials and peel strength values.

Example 1

Ethyl cellulose and butyl carbitol were added to tungsten powder materials, oxide powder materials and iron family metal powder materials shown in Table 1, and sufficiently kneaded by a triple-roll mill, to prepare metal paste materials for respective samples. The metal paste materials were applied to surfaces of sintered bodies or sheet compacts of aluminum nitride containing 1 percent by weight of $Y_2O_3$ by screen printing re-

spectively. Thereafter the samples were heated/fired in accordance with firing conditions shown in Table 1. Referring to Table 1, "$N_2$ - $5H_2$" indicates that the volume ratio of $N_2$ gas to $H_2$ gas is 95:5. On the other hand, "$50N_2$ - $50H_2$" indicates that the volume ratio of $N_2$ gas to $H_2$ gas is 50:50.

Nickel-plated layers of 1.0 $\mu$m in thickness were formed on surfaces of the as-formed metallized layers. Lead frames of copper were brazed on the nickel-plated layers. In the respective samples thus prepared, the lead frames were pulled in prescribed directions, in order to measure peel strength values as adhesive strength values of the metallized layers with respect to the aluminum nitride sintered bodies or compacts.

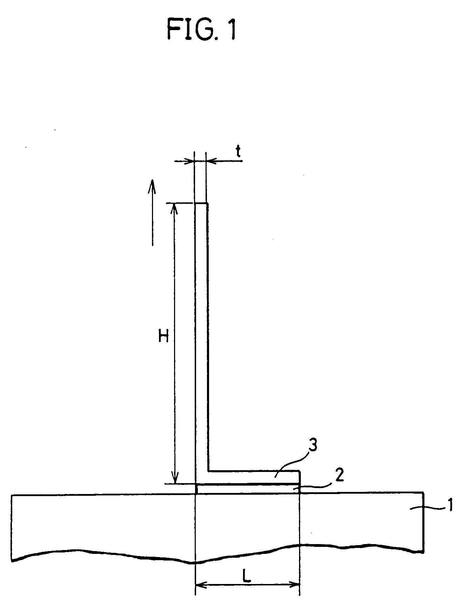

Fig. 1 shows a method of measuring peel strength. A metallized layer is formed on an aluminum nitride sintered carrier 1. A copper member (lead frame) 3 is joined on the metallized layer through a brazing layer 2. Referring to Fig. 1, symbol L denotes a length of 5 mm, symbol H denotes a height of 15 mm, and symbol $\underline{t}$ denotes a thickness of 0.2 mm. The junction area of the copper member 3 is 5 mm by 5 mm. The copper member 3 is pulled along the arrow for measuring a load for peeling the copper member 3, thereby measuring the peel strength.

Table 1 shows the adhesive strength values measured in the aforementioned manner. Samples shown with marks * are comparative samples. As understood from Table 1, the metallized layers formed according to the inventive method attained extremely high adhesive strength values of at least 5 kg/mm$^2$ with respect to the aluminum nitride sintered bodies or compacts.

Table 1        * : Comparative Sample

| Sample | Paste Component (wt. %) | | | | Print Substrate | Firing Condition | | Adhesive Strength kg/mm² |
| | W | Mo | Oxide | Fe Family | | Temperature | Atmosphere | |
|---|---|---|---|---|---|---|---|---|
| *1 | 90 | – | $Al_2O_3$ 5   CaO 5 | – | Sintered Body | 1650°C | $N_2$ – $5H_2$ | 3 |
| 2 | 80 | 10 | $Al_2O_3$ 5   CaO 5 | Fe 0.1 | Sintered Body | 1650°C | $N_2$ – $5H_2$ | 8 |
| 3 | 80 | 10 | $Al_2O_3$ 5   CaO 5 | Ni 0.1 | Sintered Body | 1550°C | $N_2$ – $5H_2$ | 10 |
| *4 | 80 | 10 | $Al_2O_3$ 5   CaO 5 | Ni 0.1 | Sintered Body | 1350°C | $N_2$ – $5H_2$ | 2 |
| 5 | 80 | 10 | $Al_2O_3$ 5   CaO 5 | Ni 0.1 | Sintered Body | 1550°C | $50N_2$ – $50H_2$ | 7 |
| 6 | 80 | 10 | $Al_2O_3$ 5   CaO 5 | Ni 0.1 | Sintered Body | 1550 °C | $N_2$ | 8 |
| 7 | 80 | 10 | $Al_2O_3$ 5   CaO 5 | Ni 0.1 | Sheet Compact | 1850°C | $N_2$ | 7 |
| 8 | 85 | 5 | $Al_2O_3$ 5   CaO 5 | Ni 0.1 | Sintered Body | 1550°C | $N_2$ | 8 |
| 9 | 85 | 5 | CaO 2 | Ni 0.01 | Sheet Compact | 1850°C | $N_2$ | 8 |
| 10 | 55 | 10 | CaO 5   $Al_2O_3$ 15   $SiO_2$ 15 | Ni 0.01 | Sintered Body | 1550°C | $N_2$ | 6 |
| 11 | 89 | 1 | $Al_2O_3$ 5   CaO 5 | Ni 0.1 | Sintered Body | 1550°C | $N_2$ | 7 |
| 12 | 50 | 50 | $Al_2O_3$ 5   CaO 5 | Ni 0.1 | Sintered Body | 1550°C | $N_2$ | 6 |
| 13 | 84 | 5 | $Al_2O_3$ 5   $Y_2O_3$ 5   CaO 1 | Ni 0.01 | Sintered Body | 1550°C | $N_2$ | 8 |
| 14 | 75 | 5 | $Al_2O_3$ 10   $SiO_2$ 10 | Ni 0.01 | Sintered Body | 1550°C | $N_2$ | 7 |
| *15 | 30 | 60 | $Al_2O_3$ 5   CaO 5 | Ni 0.1 | Sintered Body | 1550°C | $N_2$ | 3 |
| *16 | 40 | 10 | $Al_2O_3$ 25   CaO 25 | Ni 0.1 | Sintered Body | 1550°C | $N_2$ | 1 |
| *17 | 90 | 9.4 | $Al_2O_3$ 0.3   CaO 0.3 | Ni 0.1 | Sintered Body | 1550°C | $N_2$ | 2 |
| *18 | 80 | 10 | $Al_2O_3$ 5   CaO 5 | Ni 1.5 | Sintered Body | 1550°C | $N_2$ | 1 |
| 19 | 80 | 10 | $Al_2O_3$ 5   CaO 5 | Ni 0.5 | Sintered Body | 1550°C | $N_2$ | 5 |

EP 0 461 609 B1

## Example 2

Metal paste materials were prepared in a similar manner to Example 1. Tungsten powder materials were mixed with molybdenum powder materials in various weight ratios (W/Mo), while other paste components were selected in a similar manner to the sample No. 11 shown in Table 1, to prepare metal paste materials for respective samples. The as-formed metal paste materials were applied onto surfaces of aluminum nitride sintered bodies by screen printing. Thereafter the samples were heated/fired in accordance with firing conditions similar to those for the sample No. 11 shown in Table 1.

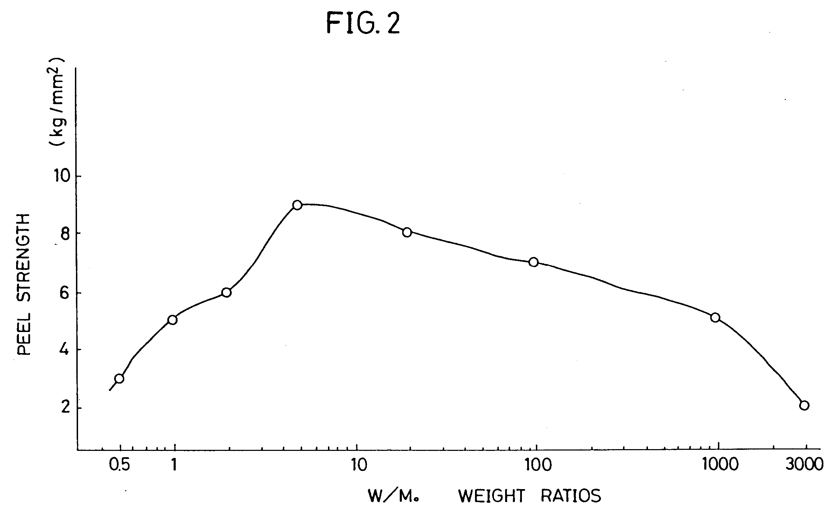

In order to evaluate the as-formed metallized layers, peel strength values were measured in a similar manner to Example 1. Fig. 2 shows the results of the measured peel strength values. As understood from Fig. 2, it is possible to attain high peel strength of at least about 5 kg/mm$^2$ when the weight ratio W/Mo is within the range of 1 to 1000. In particular, it is possible to attain high peel strength of at least about 7 kg/mm$^2$ when the weight ratio W/Mo is in a range of 5 to 100.

## Claims

1. A method of forming a metallized layer on a surface of an aluminum nitride base material, comprising the steps of:
   preparing an aluminum nitride base material from either an aluminum nitride compact or an aluminum nitride sintered body being previously formed to have a prescribed configuration;
   preparing high melting metal paste containing at least 1 percent by weight and not more than 40 percent by weight of at least one oxide selected from a group of $Al_2O_3$, $SiO_2$, CaO and $Y_2O_3$, at least 0.01 percent by weight and not more than 1.0 percent by weight of at least one iron family metal, and a high melting metal being composed of tungsten and molybdenum with a weight ratio (W/Mo) of tungsten to molybdenum of at least 1/1 and not more than 1000/1;
   applying said high melting metal paste onto a surface of said aluminum nitride base material; and
   heating/firing said aluminum nitride base material, being coated with said high melting metal paste, under a temperature of at least 1400°C and not more than 2000°C.

2. A method of forming a metallized layer in accordance with claim 1, wherein
   said aluminum nitride base material is prepared from an aluminum nitride sintered body, and
   said step of heating/firing said aluminum nitride base material being coated with said high melting metal paste includes a step of heating/firing said aluminum nitride sintered body in a non-oxidizing atmosphere containing hydrogen under a temperature of at least 1400°C and not more than 1600°C.

3. A method of forming a metallized layer in accordance with claim 1, wherein
   said aluminum nitride base material is prepared from an aluminum nitride compact, and
   said step of heating/firing said aluminum nitride base material being coated with said high melting metal paste includes a step of heating/firing said aluminum nitride compact in a non-oxidizing atmosphere containing nitrogen under a temperature of at least 1600°C and not more than 2000°C.

4. A method of forming a metallized layer in accordance with claim 1, wherein
   said weight ratio (W/Mo) is at least 5 and not more than 100.

## Patentansprüche

1. Verfahren zur Herstellung einer Metallschicht auf einer Oberfläche eines Aluminiumnitrid-Grundmaterials, welches folgende Schritte umfaßt:
   - Herstellen eines Aluminiumnitrid-Grundmaterials entweder aus einem Aluminiumnitrid-Preßkörper oder einem Aluminiumnitrid-Sinterkörper, der vorher so geformt wurde, daß er eine vorgegebene Konfiguration aufweist;
   - Herstellen einer hochschmelzenden Metallpaste, die wenigstens 1 Gew.-% und nicht mehr als 40 Gew.-% wenigstens eines Oxides, ausgewählt aus einer Gruppe von $Al_2O_3$, $SiO_2$, CaO und $Y_2O_3$, wenigstens 0,01 Gew.-% und nicht mehr als 1,0 Gew.-% wenigstens eines Metalls der Eisenfamilien und ein hochschmelzendes Metall, das aus Wolfram und Molybdän mit einem Gewichtsverhältnis (W/Mo) von Wolfram zu Molybdän von wenigstens 1/1 und nicht mehr als 1000/1 besteht, enthält;

- Aufbringen der hochschmelzenden Metallpaste auf eine Oberfläche des Aluminiumnitrid-Grundmaterials; und
- Erwärmen/Brennen des Aluminiumnitrid-Grundmaterials, das mit der hochschmelzenden Metallpaste überzogen ist, bei einer Temperatur von wenigstens 1400°C und nicht mehr als 2000°C.

2. Verfahren zum Herstellen einer Metallschicht nach Anspruch 1, wobei
   - das Aluminiumnitrid-Grundmaterial aus einem Aluminiumnitrid-Sinterkörper hergestellt wird, und
   - der Schritt des Erwärmens/Brennens des mit der hochschmelzenden Metallpaste beschichteten Aluminiumnitrid-Grundmaterials einen Schritt des Erwärmens/Brennens des Aluminiumnitrid-Sinterkörpers in einer Wasserstoff enthaltenden, nicht oxidierenden Atmosphäre bei einer Temperatur von wenigstens 1400°C und nicht mehr als 1600°C umfaßt.

3. Verfahren zum Herstellen einer Metallschicht nach Anspruch 1, wobei
   - das Aluminiumnitrid-Grundmaterial das einem Aluminiumnitrid-Preßkörper hergestellt wird, und
   - der Schritt des Erwärmens/Brennens des mit der hochschmelzenden Metallpaste beschichteten Aluminiumnitrid-Grundmaterials einen Schritt des Erwärmens/Brennens des Aluminiumnitrid-Preßkörpers in einer Stickstoff enthaltenden, nicht oxidierenden Atmosphäre bei einer Temperatur von wenigstens 1600°C und nicht mehr als 2000°C umfaßt.

4. Verfahren zum Herstellen einer Metallschicht nach Anspruch 1, wobei
   - das Gewichtsverhältnis (W/Mo) wenigstens 4 und nicht mehr als 100 beträgt.


**Revendications**

1. Procédé pour la formation d'une couche métallisée sur une surface d'un matériau à base de nitrure d'aluminium, comprenant les étapes consistant à :
   préparer un matériau à base de nitrure d'aluminium provenant soit d'un corps compact au nitrure d'aluminium, soit d'un corps fritté ou aggloméré au nitrure d'aluminium qui a été préalablement façonné pour présenter une configuration prescrite ;
   préparer une pâte de métal à point de fusion élevé contenant au moins 1 % en poids et pas plus de 40 % en poids d'au moins un oxyde choisi dans un groupe de $Al_2O_3$, $SiO_2$, Cao et $Y_2O_3$, au moins 0,01 % en poids et pas plus de 1,0 % en poids d'au moins un métal de la famille du fer, et un métal à point de fusion élevé étant constitué de tungstène et de molybdène avec un rapport pondéral (W/Mo) entre le tungstène et le molybdène d'au moins 1/1 et pas plus de 1000/1 ;
   appliquer la pâte de métal à point de fusion élevé sur une surface du matériau à base de nitrure d'aluminium ; et
   chauffer et cuire le matériau à base de nitrure d'aluminium, revêtu de la pâte de métal à point de fusion élevé à une température d'au moins 1400°C et pas plus de 2000°C.

2. Procédé pour la formation d'une couche métallisée selon la revendication 1, dans lequel
   le matériau à base de nitrure d'aluminium est préparé à partir d'un corps fritté ou aggloméré de nitrure d'aluminium, et
   l'étape de chauffage/cuisson du matériau à base de nitrure d'aluminium est revêtue de la pâte de métal à point de fusion élevé et comprend l'étape de chauffage/cuisson du corps fritté ou aggloméré de nitrure d'aluminium dans une atmosphère non oxydante contenant de l'hydrogène à une température d'au moins 1400°C et pas plus de 1600°C.

3. Procédé de formation d'une couche métallisée selon la revendication 1, dans lequel
   le matériau à base de nitrure d'aluminium est préparé à partir d'un corps compact au nitrure d'aluminium, et
   l'étape consistant à chauffer/cuire le matériau à base de nitrure d'aluminium est revêtue de la pâte de métal à point de fusion élevé et comprend une étape de chauffage/-cuisson du corps compact de nitrure d'aluminium dans une atmosphère non oxydante contenant de l'azote à une température d'au moins 1600°C et pas plus de 2000°C.

4. Procédé pour la formation d'une couche métallisée selon la revendication 1, dans lequel
   le rapport pondéral (W/Mo) est au moins de 5 et pas plus de 100.

# FIG. 1

# FIG.2